# EUROPEAN PATENT APPLICATION

(11) **EP 2 320 481 A2**
(43) Date of publication of application: **11.05.2011**
(21) Application number: 10177246.5
(22) Date of filing: 17.09.2010
(51) Int. Cl.: H01L 31/18, H01L 31/068

(54) **Solar cell and method for manufacturing the same**

(30) Priority: 04.11.2009 KR 20090106136
(71) Applicant: Samsung Electronics Co., Ltd., Suwon-si, Gyeonggi-do (KR)
(72) Inventor: Lee, Jung-Hyun, Gyeonggi-do (KR); Lee, Chang-Soo, 441-390, Gyeonggi-do (KR); Kang, Yoon-Mook, Gyeonggi-do (KR)
(74) Representative: Grünecker, Kinkeldey, Stockmair & Schwanhäusser Anwaltssozietät

(57) **Abstract**

A method of manufacturing a solar cell includes providing a semiconductor substrate (110) including a p-type layer (110a) and an n-type layer (110b). A dielectric layer (130) including aluminum oxynitride is disposed on one side of the semiconductor substrate. A first electrode (150) is in electrical communication with the p-type layer of the semiconductor substrate. A second electrode (120) is in electrical communication with the n-type layer of the semiconductor substrate. The disposing the dielectric layer (130) comprises repeatedly forming an aluminum nitride layer and substituting a part of nitrogen of the aluminum nitride layer with oxygen.

## Description

### BACKGROUND

### 1. Field

This disclosure relates to a solar cell and a method for manufacturing the same.

### 2. Description of the Related Art

A solar cell is a photoelectric conversion device that transforms solar energy into electrical energy. It has attracted much attention as an infinitely long lasting device that is pollution-free and that can serve as a next-generation energy source.

A solar cell includes p-type and n-type semiconductors and produces electrical energy by transferring electrons and holes to the n-type and p-type semiconductors respectively, when an electron-hole pair ("EHP") is produced by light energy absorbed in a photoactive layer inside the semiconductors, and then collecting the electrons and holes in each of a positive and a negative electrode.

Charges can be lost due to recombination of the produced electrons and holes. It is desirable to prevent the loss of electrical charges. In order to do this, it is desirable for a solar cell to have as high an energy conversion efficiency as possible for producing electrical energy from solar energy. In order to increase the efficiency of a solar cell, it is desirable to improve the efficiency of generation of as many electron-hole pairs as possible and to efficiently withdraw the resulting charges with minimal loss.

### SUMMARY

Electric charges may be lost due to a wide variety of different reasons. Electric charges may be lost when there are defects in a path along which electric charges are transferred. The generated electrons and holes may undergo recombination in these defects and disappear.

One aspect of this disclosure provides a method of manufacturing a solar cell having improved efficiency by decreasing the loss of produced electric charges.

Another aspect of this disclosure provides a method for manufacturing the solar cell.

According to one aspect of this disclosure, a method of manufacturing a solar cell includes providing a semiconductor substrate including a p-type layer and an n-type layer; forming a dielectric layer including aluminum oxynitride on one side of the semiconductor substrate; disposing a first electrode that is in electrical communication with the p-type layer; and forming a second electrode that is in electrical communication with the n-type layer, wherein the disposing the dielectric layer includes repeatedly forming an aluminum nitride layer and substituting a part of nitrogen of the aluminum nitride layer with oxygen.

In one aspect, the disposing the dielectric layer includes forming the dielectric layer.

The aluminum nitride layer may be disposed by a method including supplying an aluminum precursor and a nitrogen-containing gas on to the semiconductor substrate to produce the aluminum nitride.

The aluminum precursor may include a compound containing an aluminum atom and further having at least one of hydrogen, a substituted or unsubstituted C₁ to C₃₀ alkyl group, a substituted or unsubstituted C₆ to C₃₀ cycloalkyl group, a substituted or unsubstituted C₆ to C₃₀ aromatic group, a substituted or unsubstituted amide group, a substituted or unsubstituted alkoxy group, or a combination thereof.

The aluminum precursor may include trimethylaluminum.

The nitrogen-containing gas may include ammonia gas (NH₃), nitrogen gas (N₂), or a combination thereof.

The disposing of the dielectric layer may be performed by chemical vapor deposition ("CVD").

In one aspect, the chemical vapor deposition may be performed at a temperature of about 100°C to about 500°C.

In another aspect, the chemical vapor deposition may be performed at a temperature of about 250°C to about 350°C.

The manufacturing method may further include performing a purging process between the forming the aluminum nitride layer and the substituting a part of the nitrogen of the aluminum nitride layer with oxygen.

The substituting a part of the nitrogen of the aluminum nitride layer may comprise supplying activated oxygen to the aluminum nitride layer.

The aluminum oxynitride may be represented by the following Chemical Formula 1.

AlOₓN_{y} [Chemical Formula 1]

In the Chemical Formula 1, 0<y<x and y/x+y ≤ 0.01.

The manufacturing method may further include firing the first electrode and the second electrode, and the dielectric layer after the firing is of an amorphous state.

According to another aspect of this disclosure, a solar cell includes a semiconductor substrate with a p-type layer and an n-type layer; a dielectric layer formed on one side of the semiconductor substrate and including amorphous aluminum oxynitride; a first electrode in electrical communication with the p-type layer of the semiconductor substrate; and a second electrode in electrical communication with the n-type layer of the semiconductor substrate.

The dielectric layer may have a thickness ranging from about 10 nanometers ("nm") to about 700 nm.

The dielectric layer may have a thickness ranging from about 20 nm to about 400 nm.

The dielectric layer may have a thickness ranging from about 30 nm to about 100 nm.

The dielectric layer may include oxygen and nitrogen uniformly distributed in a direction determined by the thickness of the film.

The dielectric layer may include a plurality of aluminum oxynitride layers stacked therein. The plurality of oxynitride layers are obtained by oxidizing the aluminum nitride layers.

The amorphous aluminum oxynitride may be represented by the Chemical Formula 1.

The solar cell is formed on one side of the dielectric layer, and the solar cell may further include a protective layer having a lower refractive index than the dielectric layer.

The protective layer may include silicon nitride, silicon oxide, aluminum oxide, or a combination thereof.

The dielectric layer and the first electrode may be disposed on a rear side of the semiconductor substrate, and the first electrode penetrates through the dielectric layer and partially contacts the semiconductor substrate.

### BRIEF DESCRIPTION OF THE DRAWINGS

FIG. 1 is a cross-sectional view of an exemplary solar cell;
FIGS. 2 to 8 are cross-sectional views sequentially showing a method of manufacturing an exemplary solar cell ;
FIGS. 9A to 9F are cross-sectional views sequentially showing a method of providing a dielectric layer;
FIG. 10A is a transmission electron microscope (TEM) photomicrograph showing aluminum oxynitride non-crystallized after heat treatment is performed at about 950°C for about 3 seconds;
FIG. 10B is a transmission electron microscope (TEM) photomicrograph showing aluminum oxide (Al₂O₃) crystallized after heat treatment is performed at about 950°C for about 3 seconds; and
FIG. 10C is a transmission electron microscope (TEM) photomicrograph showing aluminum nitride (AIN) crystallized after heat treatment is performed at about 950°C for about 3 seconds.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting. As used herein, the singular forms "a," "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another elements as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

All numerical ranges disclosed herein are inclusive of the numbers used to encompass the range. Further all numbers in a range or a series of ranges are interchangeable.

The transition term "comprises" encompasses the transition terms "consisting essentially of" or the transition term "consisting of".

As used herein, when a definition is not otherwise provided, the term "substituted" refers to a compound substituted with a substituent of a C₁ to C₃₀ alkyl group, a C₂ to C₃₀ alkynyl group, a C₆ to C₃₀ aryl group, a C₇ to C₃₀ arylalkyl group, a C₁ to C₄ oxyalkyl group, a C₁ to C₃₀ heteroalkyl group, a C₃ to C₃₀ heteroarylalkyl group, a C₃ to C₃₀ cycloalkyl group, a C₃ to C₁₅ cycloalkenyl group, a C₆ to C₃₀ cycloalkynyl group, a C₂ to C₃₀ heterocycloalkyl group, a halogen (F, Cl, Br, I), a hydroxy group, an alkoxy group, a nitro group, a cyano group, an amino group, an azido group, an amidino group, a hydrazino group, a hydrazono group, a carbonyl group, a carbamyl group, a thiol group, an ester group, a carboxyl group or salts thereof, a sulfonic acid group or salts thereof, phosphoric acid or salts thereof, or a combination thereof.

In the drawings, the thickness of layers, films, panels, regions, and the like, are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

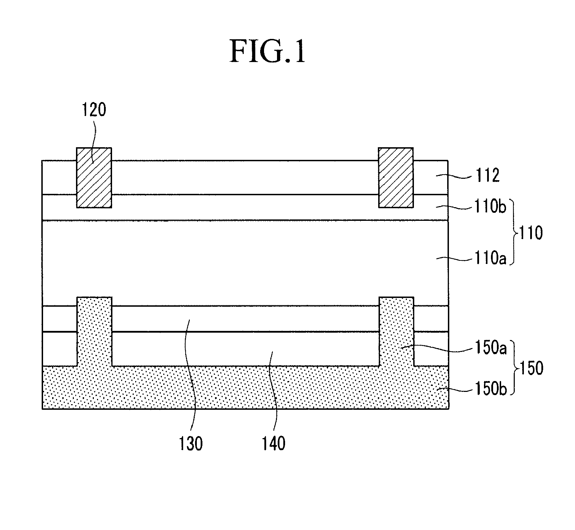

FIG. 1 is a cross-sectional view of an exemplary solar cell.

Hereafter, a side of a semiconductor substrate 110 that receives solar energy is referred to as a front side, and the side opposite to the front side of the semiconductor substrate 110 is referred to as a rear side. Hereinafter, for better understanding and ease of description, the relationship between the upper and lower positions is described from the center of the semiconductor substrate 110, but is not limited thereto.

The semiconductor substrate of the solar cell includes a semiconductor substrate 110 including a lower semiconductor layer 110a and an upper semiconductor layer 110b. In one embodiment, the upper semiconductor layer 110b is disposed upon and in intimate contact with the lower semiconductor layer 110a.

The semiconductor substrate 110 may be formed of a crystalline silicon or a compound semiconductor. A silicon wafer that includes crystalline silicon may be used. Either the lower semiconductor layer 110a or the upper semiconductor layer 110b may be doped with a p-type impurity, while the other semiconductor layer may be doped with an n-type impurity. The p-type impurity may be a Group III element such as boron (B), while the n-type impurity may be a Group V element such as phosphorus (P).

The semiconductor substrate 110 may have a textured surface. The surface-textured semiconductor substrate 110 may, for example, have protrusions and depressions such as, for example pyramids, or pores that resemble a honeycomb. The surface-textured semiconductor substrate 110 has an enlarged surface area to enhance the amount and the rate of light-absorption and to decrease the reflection rate, thereby significantly improving the efficiency of a solar cell.

An anti-reflection layer 112 is disposed on the front side of the semiconductor substrate 110. In other words, the anti-reflection layer 112 is formed on the side of the semiconductor substrate 110 where incident light (that generates electrons for the functioning of the solar cell) first impinges upon the solar cell. The anti-reflection layer 112 may be formed of an insulating material that reflects little light, for example, silicon nitride (SiNₓ), silicon oxide (SiO₂), titanium oxide (TiO₂), aluminum oxide (Al₂O₃), magnesium oxide (MgO), cerium oxide (CeO₂), or the like, or a combination comprising at least one of the foregoing insulating materials. The anti-reflection layer may be a single layer thick or may include a plurality of layers.

The anti-reflection layer 112 may have a thickness ranging from about 200 Angstroms ("A") to about 1500Å, specifically about 300A to about 1400A, and more specifically about 400 to about 1200Å.

The anti-reflection layer 112 may decrease the reflection rate of light and increase selectivity of a particular wavelength or a particular range of wavelengths on the front side of the solar cell. The anti-reflection layer 112 may be manufactured from a material that is effective to improve its contact properties with the silicon in the surface of the semiconductor substrate 110, thereby increasing the efficiency of the solar cell.

A plurality of front electrodes 120 are disposed on the anti-reflection layer 112. The front electrodes 120 are arranged to be parallel to one another and to be perpendicular to the semiconductor substrate 110. The plurality of front electrodes 120 penetrate the anti-reflection layer 112 and contact the second semiconductor layer 110b. The front electrodes 120 may include a low-resistance material such as silver (Ag), aluminum (Al), or the like, and may be designed to have a grid pattern to reduce shadowing loss as well as the sheet resistance.

A dielectric layer 130 is disposed on the rear side of the semiconductor substrate 110. As noted above, the rear side is the side that is opposed to the front side. The front side is the side upon which incident light first impinges.

In one embodiment, the dielectric layer 130 includes aluminum oxynitride.

The aluminum oxynitride may be represented by the following Chemical Formula 1.

AlOₓN_{y} [Chemical Formula 1]

In the Chemical Formula 1, 0<y<x and y/x+y ≤ 0.01.

The dielectric layer 130 is formed of aluminum oxynitride, which is an aluminum oxide that includes a small amount of nitrogen. The aluminum oxynitride maintains its amorphous state even after heat treatment at a high temperature, because the small amount of nitrogen present inhibits its crystallization. In an exemplary embodiment, the aluminum oxynitride is amorphous without any grain boundaries.

The amorphous aluminum oxynitride does not have grain boundaries because of the lack of crystallization, and hence electric charges are not trapped at the grain boundary and are kept from being lost at the grain boundaries.

However, when the dielectric layer is formed of a material such as aluminum oxide (Al₂O₃) or aluminum nitride (AIN) that can crystallize at a high temperature, electric charges may end up being trapped at the grain boundaries and the electric charges will then be lost.

Since the dielectric layer 130 has a fixed charge, it prevents electric charges generated in the semiconductor substrate 110 from transferring to the rear side of the semiconductor substrate 110. When the dielectric layer 130 contains a plurality of negative charges, it inhibits electrons, which are minor charges existing in a lower semiconductor layer 110a, from transferring to the rear side. Thus, the electrons will be prevented from being recombined with holes and disappearing. The loss of electric charges is thus reduced and the efficiency of a solar cell is increased.

A protective layer 140 is disposed under the dielectric layer 130. The protective layer 140 is disposed on a side of the dielectric layer 130 that is opposed to the side that contacts the lower semiconductor layer 110a.

The protective layer 140 is optional may be formed of a material having a lower refractive index than the dielectric layer 130, and for example, the protective layer 140 may be formed of silicon oxide (SiO₂), silicon nitride (SiNₓ), aluminum oxide (Al₂O₃), or the like, or a combination comprising at least one of the foregoing.

The protective layer 140 reflects light that has been transmitted through the upper semiconductor layer 110b and the lower semiconductor layer 110a back to the substrate 110. This reflected light is then reabsorbed in the substrate thereby minimizing the loss of light and increasing the overall efficiency of the solar cell. In addition, the protective layer 140 protects the dielectric layer 130 and semiconductor substrate 110 from being damaged during the high-temperature firing when a rear electrode 150 is formed. However, if the dielectric layer 130 sufficiently reflects the light, and is thick enough to protect the semiconductor substrate 110, the use of a protective layer 140 may be avoided.

Meanwhile, when the dielectric layer 130 is formed at a rate that is slower than the rate of formation of the protective layer 140, it is possible to have a passivation characteristic that protects the semiconductor substrate 110. This may also increase the process speed for forming an additional thin film (not shown) having a predetermined thickness after forming the dielectric layer 130 under the semiconductor substrate 110.

The rear electrode 150 is disposed under the protective layer 140 and contacts it. The rear electrode 150 may be formed of an opaque metal such as aluminum (Al), and it may have a thickness of about 2 micrometers ("µm") to about 50µm.

The rear electrode 150 includes a plurality of contact portions 150a and a whole portion 150b. The contact portions 150a penetrate the dielectric layer 130 and the protective layer 140 to thereby contact the lower semiconductor layer 110a. The whole portion 150b covers the entire surface of the substrate.

A back surface field (BSF) may be generated at a position where the lower semiconductor layer 110a of the semiconductor substrate 110 and the contact portion 150a of the rear electrode 150 contact each other. The back surface field is an internal electric field generated between the lower semiconductor layer 110a and the contact portion 150a when aluminum from the electrode functions as a p-type impurity where the silicon and aluminum contact each other. With the back surface field, it is possible to prevent electrons from transferring to the rear side of the semiconductor substrate 110. Accordingly, electrons are kept from being recombined with holes in the rear side of the semiconductor substrate 110 and thereby disappearing. This increases the efficiency of the solar cell.

The whole portion 150b of the rear electrode 150 reflects light that has been transmitted through the semiconductor substrate 110 back to the semiconductor substrate 110 to prevent the light loss and to increase the efficiency of the solar cell.

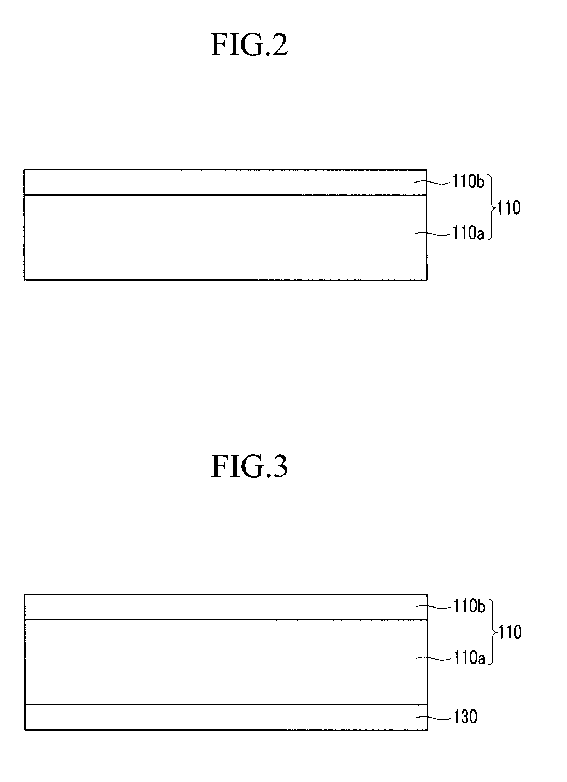

Hereafter, a method for manufacturing a solar cell according to one embodiment will be described with reference to FIGS. 2 to 9F along with FIG. 1.

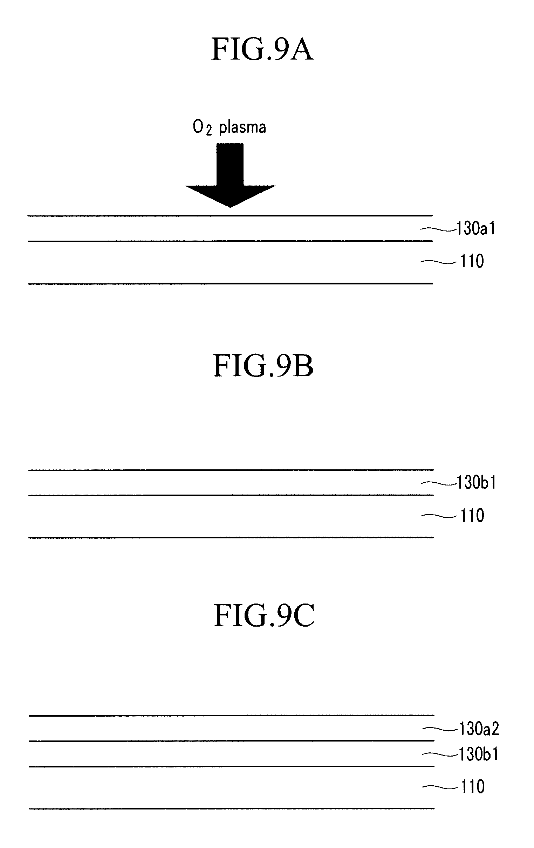

FIGS. 2 to 8 are cross-sectional views sequentially showing a method of manufacturing an exemplary solar cell, and FIGS. 9A to 9F are cross-sectional views sequentially showing a method of manufacturing the dielectric layer.

A semiconductor substrate 110 including a silicon wafer is provided. The semiconductor substrate 110 may be doped with a p-type impurity.

Next, the semiconductor substrate 110 is subjected to surface-texturing. The surface-texturing may be performed using a wet method that involves a strong acid such as nitric acid and hydrofluoric acid or a strong base such as sodium hydroxide. In one embodiment, a dry method involves using a plasma to provide the texturing.

Ref erring to FIG. 2, the semiconductor substrate 110 may be doped with an n-type impurity. The n-type impurity may be doped by diffusing phosphorus oxychloride (POCl₃), phosphoric acid (H₃PO₄), or the like at a high temperature. The semiconductor substrate 110 includes a lower semiconductor layer 110a and an upper semiconductor layer 110b that are doped with different impurities.

Referring to FIG. 3, the dielectric layer 130 is formed of aluminum oxynitride under the rear side of the semiconductor substrate 110. The dielectric layer 130 may be manufactured using chemical vapor deposition (CVD). Other methods of manufacturing the dielectric layer 130 include remote plasma-enhanced CVD (RPECVD), atomic layer CVD (ALCVD), combustion chemical vapor deposition (CCVD), hot wire CVD (HWCVD) - also known as catalytic CVD (Cat-CVD) or hot filament CVD (HFCVD), metalorganic chemical vapor deposition (MOCVD), hybrid physical-Chemical Vapor Deposition (HPCVD), or rapid thermal CVD (RTCVD). A method for forming the dielectric layer 130 will be described later.

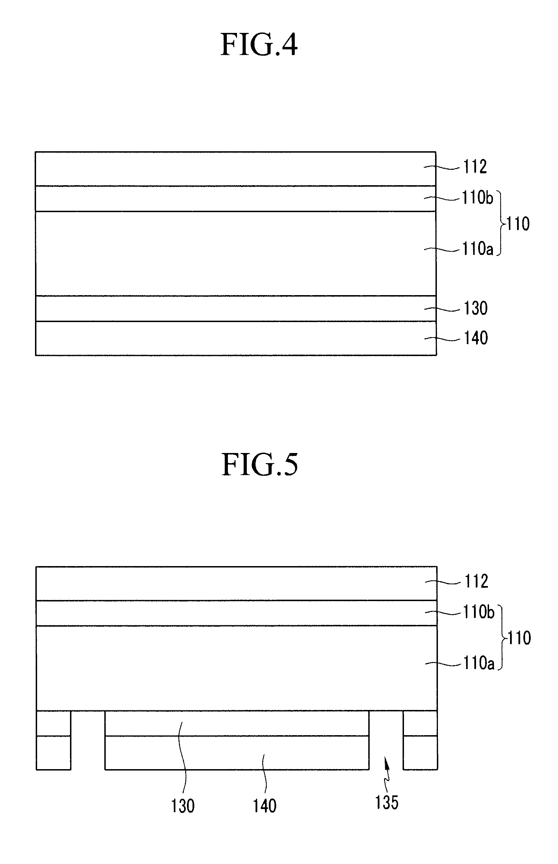

Referring to FIG. 4, an anti-reflection layer 112 and a protective layer 140 are formed on the front side and under the rear side respectively of the semiconductor substrate 110. The anti-reflection layer 112 and the protective layer 140 may be formed of a material such as a silicon nitride through plasma enhanced chemical vapor deposition (PECVD). Other methods of manufacturing the anti-reflection layer 112 and the protective layer 140 include remote plasma-enhanced CVD (RPECVD), atomic layer CVD (ALCVD), combustion chemical vapor deposition (CCVD), hot wire CVD (HWCVD) - also known as catalytic CVD (Cat-CVD) or hot filament CVD (HFCVD), metalorganic chemical vapor deposition (MOCVD), hybrid physical-Chemical Vapor Deposition (HPCVD), or rapid thermal CVD (RTCVD).

The present embodiment is not limited thereto, and the anti-reflection layer 112 and the protective layer 140 may be formed of other materials through other methods.

Referring to FIG. 5, a portion of the dielectric layer 130 and a portion of the protective layer 140 are removed to form a plurality of contact holes 135 and expose a portion of the lower semiconductor layer 110a to the rear end. A portion of the dielectric layer 130 and a portion of the protective layer 140 may be removed by using a laser or by performing a photolithographic process using a photosensitive layer.

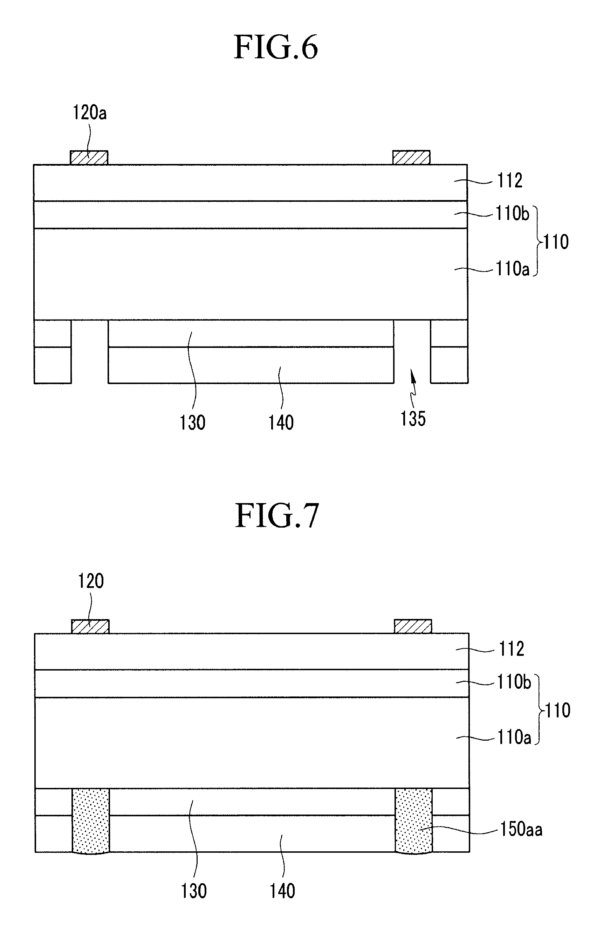

Referring to FIG. 6, a conductive paste 120a is applied on the anti-reflection layer 112 to form the front electrode 120.

The conductive paste 120a for the front electrode 120 may include a metal powder such as silver (Ag), and the front electrode may be formed through a screen printing method, which includes applying the conductive paste 120a to an area where the front electrode is to be formed. After its application, the applied conductive paste 120a is dried.

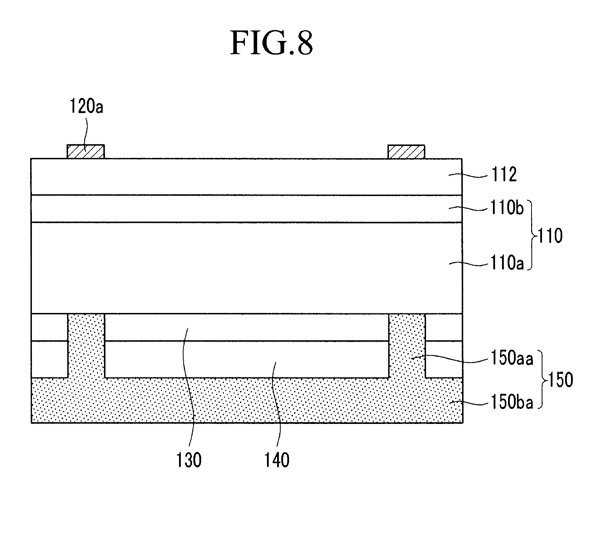

Referring to FIGS. 7 and 8 sequentially, the contact holes 135 are filled with the conductive paste 150aa for the rear electrode, and a conductive paste 150ba (also for the rear electrode) is applied as shown in the FIG. 8 to cover the entire rear side of the semiconductor substrate.

The conductive pastes 150aa and 150ba for the rear electrode may include a metal powder such as aluminum (Al), and the rear electrode may be formed through a screen printing process. The screen printing process includes applying the conductive pastes 150aa and 150ba for the rear electrode to an area where the rear electrode is to be formed and drying the applied conductive pastes 150aa and 150ba to manufacture the rear electrode.

This disclosure, however, is not limited to the screen printing method, and diverse methods, such as inkjet printing and imprinting, may be used.

Subsequently, the semiconductor substrate 110 with the applied conductive pastes 120a, 150aa, and 150ba is fired in a high-temperature furnace. The firing process may be performed at a temperature higher than the melting point of the metal powder, such as, for example, at a temperature of about 600°C to about 1000°C.

Referring to FIG. 1, as a result of the firing process, the conductive paste 120a penetrates through the anti-reflection layer 112 to contact the upper semiconductor layer 110b, and the conductive paste 150aa contacts the lower semiconductor layer 110a through the contact holes 135 formed in the dielectric layer 130 and the protective layer 140.

Hereafter, a method for forming the dielectric layer 130 will be described with reference to FIGS. 9A to 9B.

Referring to FIG. 9A, the semiconductor substrate 110 is positioned in a chamber (not shown) for chemical vapor deposition (CVD), and an aluminum precursor and a nitrogen-containing gas are supplied to a surface of the semiconductor substrate 110 to deposit an aluminum nitride layer 130a1.

The aluminum precursor is not limited and any aluminum precursor that may be deposited as a thin film by plasma may be used. For example, the aluminum precursor may include a compound having an aluminum atom that is covalently bonded to at least one of a hydrogen, a substituted or unsubstituted C₁ to C₃₀ alkyl group, a substituted or unsubstituted C₆ to C₃₀ cycloalkyl group, a substituted or unsubstituted C₆ to C₃₀ aromatic group, a substituted or unsubstituted amide group, or to a substituted or unsubstituted alkoxy group, or a combination thereof. In one embodiment, the aluminum precursor may include trimethylaluminum.

The nitrogen-containing gas is not limited and any gas that contains nitrogen that can be combined with aluminum may be used. For example, ammonia gas (NH₃), nitrogen gas (N₂), or a combination thereof may be used.

The aluminum nitride layer 130a1 may be deposited at a temperature of about 100°C to about 500°C, and specifically about 250°C to about 350°C. As the deposition is performed in the above temperature range, it is possible to prevent the silicon exposed in the surface of the semiconductor substrate from being incompletely oxidized while the aluminum precursor and the nitrogen-containing gas are effectively decomposed. It is therefore possible to prevent incompletely oxidized silicon oxide (SiOx (0<x<2)) from being formed on the surface of the semiconductor substrate.

The chamber is then purged to remove the aluminum precursor and the nitrogen-containing gas from the chamber. An inert gas such as argon (Ar) may be supplied for the purging process.

After the purging, an activated oxygen-containing gas is supplied to the upper portion of the aluminum nitride layer 130a1. At least a portion of the nitrogen of the aluminum nitride layer 130a1 is substituted with oxygen by supplying the activated oxygen-containing gas on the aluminum nitride layer 130a1. The presence of the nitrogen in the aluminum oxynitride layer is advantageous in that it prevents the formation of crystalline grains and consequently crystalline grain boundaries.

As for the oxygen-containing gas, any gas that may provide oxygen atoms to be combined with aluminum may be used, such as oxygen gas (O₂), ozone (O₃), or a combination thereof. FIG. 9A exemplarily illustrates plasma using oxygen gas (O₂), but this disclosure is not limited thereto.

Also, it is possible to use a heat oxidation method in which annealing is performed in the oxygen atmosphere.

Accordingly, as shown in FIG. 9B, an aluminum oxynitride layer 130b1 is formed.

The aluminum oxynitride layer 130b1 may have a thickness ranging from about 0.5 nm to about 3 nm, specifically about 1 nm to about 2 nm. The thickness range may be adjusted according to process conditions and the equipment used. Within the thickness range, a dense thin film may be uniformly formed and at the same time an appropriate proc ess ti me may be utilized. Since oxygen is uniformly substituted in the aluminum nitride, a thin film having a uniform oxygen distribution may be formed.

The chamber is then purged to remove the oxygen-containing gas from the chamber. For the purging process, an inert gas such as argon (Ar) may be used. The process of forming the aluminum oxynitride is repeated to form a plurality of aluminum oxynitride layers. These processes are detailed below and are similar to the steps enumerated above.

Referring to FIG. 9C, an aluminum precursor and a nitrogen-containing gas are supplied again on the aluminum oxynitride layer 130b1 to thereby deposit an aluminum nitride layer 130a2. The deposition of the aluminum nitride layer 130a2 may also be performed at a temperature of about 100°C to about 500°C, and more specifically at a temperature of about 250°C to about 350°C.

A purging process is then performed to remove the aluminum precursor and the nitrogen-containing gas from the chamber.

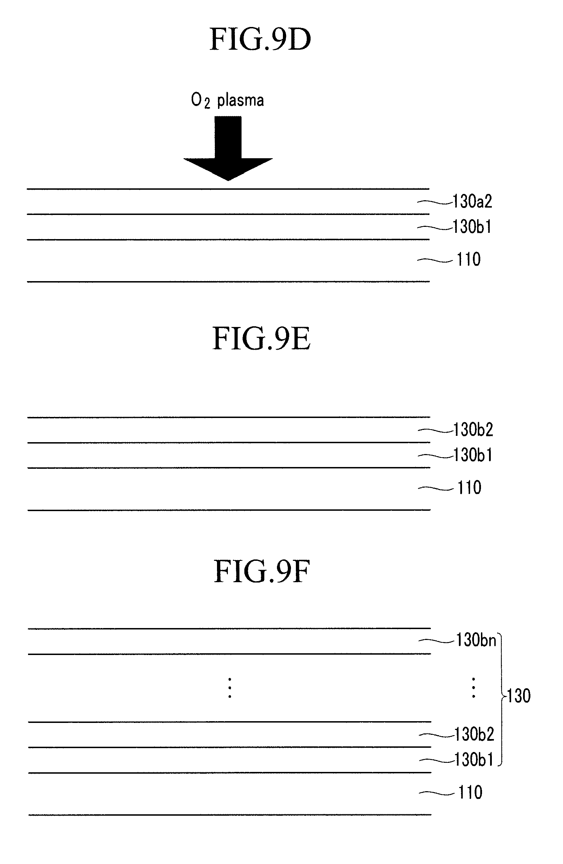

Referring to FIG. 9D, an oxygen-containing gas is supplied on the aluminum nitride layer 130a2 by O₂ plasma.

Accordingly, as shown in FIG. 9E, this results in the formation of the aluminum oxynitride layer 130b2.

Following this, the chamber is purged to remove the oxygen-containing gas from it.

Referring to FIG. 9F, the process of forming aluminum nitride by first supplying an aluminum precursor and a nitrogen-containing gas and then supplying an oxygen-containing gas are repeatedly performed n times to thereby form the dielectric layer 130 of aluminum oxynitride.

The dielectric layer 130 formed of aluminum oxynitride may have a thickness of about 10 nm to about 700 nm, specifically about 20 nm to about 400 nm, and more specifically about 30 nm to about 100 nm.

While the dielectric layer 130 containing the aluminum oxynitride is formed through a chemical vapor deposition (CVD) method, it can also be formed by other methods. When the dielectric layer is formed through the chemical vapor deposition (CVD) method, it is possible to prevent the loss of electric charges or processing deterioration, especially when compared with a method involving sputtering or atomic vapor deposition.

According to one embodiment, when the dielectric layer is formed through a sputtering method, plasma may strongly affect the surface of the semiconductor substrate 110 especially when sputtering is used in a high vacuum chamber. The effect is detrimental and damages the surface of the semiconductor substrate 110. This damage increases leakage currents in the surface of the semiconductor substrate 110 and the interface between the semiconductor substrate 110 and the dielectric layer 130 is deteriorated so that electric charges are lost. If the dielectric layer is formed through an atomic vapor deposition method, the deposition speed is so slow that it takes long time to form a dielectric layer having the desired thickness. Such a low process efficiency may be undesirable as it increases processing costs.

As noted above, the dielectric layer 130 is formed by supplying an aluminum precursor and a nitrogen-containing gas to the surface of the substrate 110 to form an aluminum nitride first. The aluminum nitride is then oxidized to form the aluminum oxynitride. The dielectric layer 130 formed through this method is dense, compared with an aluminum oxynitride formed by supplying an aluminum precursor, a nitrogen-containing gas, and an oxygen-containing gas simultaneously. by manufacturing a dense dielectric layer 130 loss of electric charges may be prevented and the efficiency of the solar cell can be improved.

The dielectric layer 130 may be manufactured by having oxygen and nitrogen uniformly distributed all over the dielectric layer by repeatedly forming thin aluminum oxynitride layers over one another a plurality of times. Therefore, the amount of fixed charges may be maintained all over the dielectric layer 130 and thus the efficiency of the solar cell is increased.

The aluminum oxynitride layer manufactured by this method may be maintained in an amorphous state without being crystallized even after a high-temperature heat treatment such as the firing of an electrode.

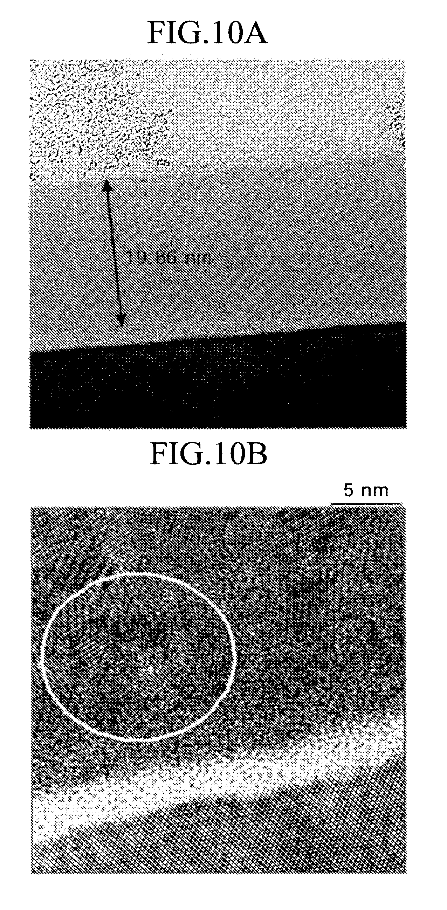

This following description is directed to the FIGS. 10A to 10C.

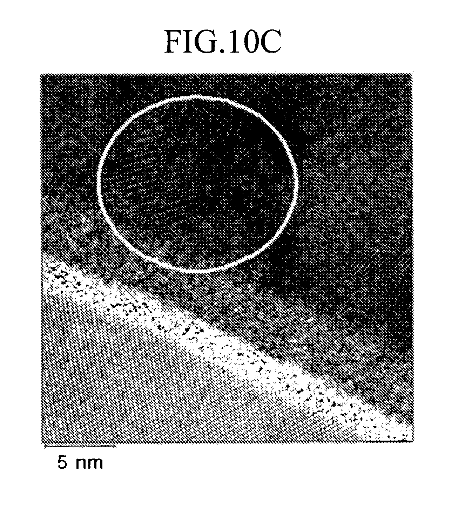

FIG. 10A is a transmission electron microscope (TEM) photograph showing a non-crystallization (amorphous) form of aluminum oxynitride obtained after heat treatment is performed on the aluminum oxynitride at about 950°C for about 3 minutes, and FIG. 10B is a TEM photograph showing a crystalline form of aluminum oxide (Al₂O₃) obtained after heat treatment is performed on the aluminum oxide (Al₂O₃) at about 950°C for about 3 minutes. FIG. 10C is a TEM photograph showing a crystalline form of aluminum nitride (AIN) obtained after heat treatment is performed on the aluminum nitride (AIN) at about 950°C for about 3 minutes.

Referring to FIG. 10A, the aluminum oxynitride formed according to one embodiment is not crystallized even after a heat treatment and continues to remain in an amorphous state. In contrast, aluminum oxide (Al₂O₃) and aluminum nitride (AIN) were crystallized through heat treatment to form crystalline regions, which are the regions marked with a circle in FIGS. 10B and 10C.

When there is a crystalline region in the dielectric layer such as aluminum oxide (Al₂O₃) and aluminum nitride (AIN), electric charges may be trapped at the grain boundaries and lost, thereby reducing the efficiency of a solar cell. However, when the dielectric layer is manufactured from aluminum oxynitride, it is not crystallized even after a high-temperature heat treatment and the grain boundaries are not formed. The lack of grain boundaries prevents electric charges from being lost.

Thus a solar cell including a dielectric layer prepared in the manner detailed above experiences a reduced loss of electric charges when compared with other comparative solar cells that contain crystalline dielectric materials. The presence of the amorphous dielectric layer reduces the amount of leakage current and increases the open voltage (V_{oc}). The method used makes it possible to protect the semiconductor substrate and the dielectric layer from defects and facilitates an improvement in the interface characteristics between the semiconductor substrate and the dielectric layer. This improves the efficiency of a solar cell.

While this invention has been described in connection with what is presently considered to be practical exemplary embodiments, it is to be understood that the invention is not limited to the disclosed embodiments, but, on the contrary, is intended to cover various modifications within the scope of the appended claims.

## Claims

1. A method of manufacturing a solar cell, comprising:
providing a semiconductor substrate including a p-type layer and an n-type layer; the p-type layer being disposed on the n-type layer;
disposing a dielectric layer including aluminum oxynitride on one side of the semiconductor substrate;
disposing a first electrode that is in electrical communication with the p-type layer of the semiconductor substrate; and
disposing a second electrode that is in electrical communication with the n-type layer of the semiconductor substrate,
wherein the forming the dielectric layer comprises repeatedly forming an aluminum nitride layer and substituting a part of nitrogen of the aluminum nitride layer with oxygen.

2. The method of claim 1, wherein the forming the aluminum nitride layer comprises supplying an aluminum precursor and a nitrogen-containing gas to a surface of the semiconductor substrate; in particular, wherein the nitrogen-containing gas comprises ammonia gas, nitrogen gas, or a combination thereof.

3. The method of claim 2, wherein the aluminum precursor comprises a compound containing aluminum combined with at least one of hydrogen, a substituted or unsubstituted C₁ to C₃₀ alkyl group, a substituted or unsubstituted C₆ to C₃₀ cycloalkyl group, a substituted or unsubstituted C₆ to C₃₀ aromatic group, a substituted or unsubstituted amide group, a substituted or unsubstituted alkoxy group, or a combination thereof; in particular, wherein the aluminum precursor comprises trimethylaluminum.

4. The method of claim 2 or 3, wherein the forming of the dielectric layer is performed by chemical vapor deposition.

5. The method of claim 4, wherein the chemical vapor deposition is performed at a temperature of 100°C to 500°C; in particular, wherein the chemical vapor deposition is performed at a temperature of 250°C to 350°C.

6. The method of claim 4 or 5, further comprising
performing a purging process between the forming of the aluminum nitride layer and the substituting a part of the nitrogen of the aluminum nitride layer with oxygen.

7. The method of one of claims 1 to 6, wherein the substituting a part of the nitrogen of the aluminum nitride layer comprises supplying activated oxygen to the aluminum nitride layer.

8. The method of one of claims 1 to 7, wherein the aluminum oxynitride comprises a compound represented by the following Chemical Formula 1:
AlOₓ,N_{y} [Chemical Formula 1]
wherein, in the Chemical Formula 1, 0<y<x and y/x+y ≤ 0.01.

9. The method of one of claims 1 to 8, further comprising firing the first electrode and the second electrode, and wherein the dielectric layer after the firing is in an amorphous form.

10. A solar cell comprising:
a semiconductor substrate (110) comprising a p-type layer (110a, 110b) and an n-type layer (110b, 110a);
a dielectric layer (130) including amorphous aluminum oxynitride; wherein the dielectric layer is disposed on the semiconductor substrate;
a first electrode (120, 150) being in electrical communication with the p-type layer of the semiconductor substrate; and
a second electrode (150, 120) being in electrical communication with the n-type layer of the semiconductor substrate.

11. The solar cell of claim 10, wherein the dielectric layer has a thickness ranging from 10 nm to 700 nm; in particular, wherein the dielectric layer has a thickness ranging from 10 nm to 400 nm; more particularly, wherein the dielectric layer has a thickness ranging from 10 nm to 100 nm.

12. The solar cell of claim 10 or 11, wherein the dielectric layer comprises a plurality of aluminum oxynitride layers formed by oxidizing aluminum nitride, wherein the dielectric layer preferably comprises oxygen and nitrogen uniformly distributed in a thickness direction.

13. The solar cell of one of claims 10 to 12, wherein the amorphous aluminum oxynitride is represented by the following Chemical Formula 1:
AlOₓN_{y} [Chemical Formula 1]
wherein, in the Chemical Formula 1, 0<y<x and y/x+y ≤ 0.01.

14. The solar cell of one of claims 10 to 13, further comprising a protective layer (140) formed on one side of the dielectric layer, and that has a lower refractive index than the dielectric layer; in particular, wherein the protective layer comprises silicon nitride, silicon oxide, aluminum oxide, or a combination thereof.

15. The solar cell of one of claims 10 to 14, wherein the dielectric layer and the first electrode are disposed on a rear side of the semiconductor substrate, and the first electrode penetrates through the dielectric layer and partially contacts the semiconductor substrate.
